# EUROPEAN PATENT APPLICATION

(11) **EP 1 014 383 A2**
(43) Date of publication of application: **28.06.2000**
(21) Application number: 99310195.5
(22) Date of filing: 16.12.1999
(51) Int. Cl.: G11C 16/22

(54) **Lock bit for an electrically erasable memory word**

(30) Priority: 21.12.1998 US 217687
(71) Applicant: Fairchild Semiconductor Corporation, South Portland, Maine 04106 (US)
(72) Inventor: Rapp, Karl, Los Gatos, California 95032 (US)
(74) Representative: W.P. THOMPSON & CO.

(57) **Abstract**

An integrated circuit memory includes a plurality of memory cells for storing a data word. A lock bit cell is coupled to the memory cells. The lock bit cell stores a lock bit associated with the data word. The lock bit can be set to a locked state to prevent overwriting of the data word.

## Description

### TECHNICAL FIELD OF THE INVENTION

This invention relates generally to the field of integrated circuit memory, and more particularly, to a lock bit for an electrically erasable memory word.

### BACKGROUND OF THE INVENTION

One type of integrated circuit (IC) memory is electrically erasable (EE) memory. An EE memory device comprises a plurality of non-volatile memory cells. Each memory cell functions to store a separate bit of data which can be programmed by application of a relatively large electrical voltage thereon. An EE memory device is typically organized such that data is written into and read out of respective memory cells in groups of related bits, each group commonly referred to as a "word" of data, such as, for example, one byte. For certain applications, it is advantageous to prevent some words (e.g., bytes) of memory from being altered once the memory cells within those words have been programmed.

### SUMMARY

According to one embodiment of the present invention, an integrated circuit memory includes a plurality of memory cells for storing a data word (e.g., a byte). 'The lock bit cell stores a lock bit associated with the data word. The memory cells and the lock bit cell can be non-volatile cells. The lock bit can be set to a locked state to prevent overwriting of the associated data word.

According to another embodiment of the present invention, an integrated circuit memory includes a word column having plurality of memory cells organized into groups. Each group of memory cells is selectable with a respective word line and can store a respective data word. Each memory cell within a group is selectable with a respective bit line. A lock bit column has a plurality of lock bit cells, each of which is associated with a respective group of memory cells. Each lock bit cell is selectable with the same word line as that for selecting the associated group of memory cells and a respective bit line. Each lock bit cell stores a respective lock bit. Each lock bit can be set to a locked state to prevent overwriting of the data word stored in the associated group of memory cells.

A technical advantage of the present invention includes providing one or more lock bits in an electrically erasable (EE) memory, each lock bit for preventing access to change the contents of one or more memory cells which store a word (e.g., byte) of data associated with the lock bit. Another technical advantage of the present invention includes providing an architecture for implementing each such lock bit that does not significantly increase the die size of an IC device in which the EE memory is implemented. Yet another technical advantage of the present invention includes integrating the lock bits within the same basic topological structure of established EE memories. Other aspects and advantages of the present invention will become apparent from the following descriptions and accompanying drawing.

### BRIEF DESCRIPTION OF THE DRAWING

For a more complete understanding of the present invention and for further features and advantages, reference is now made to the following description taken in conjunction with the accompanying drawing, in which:

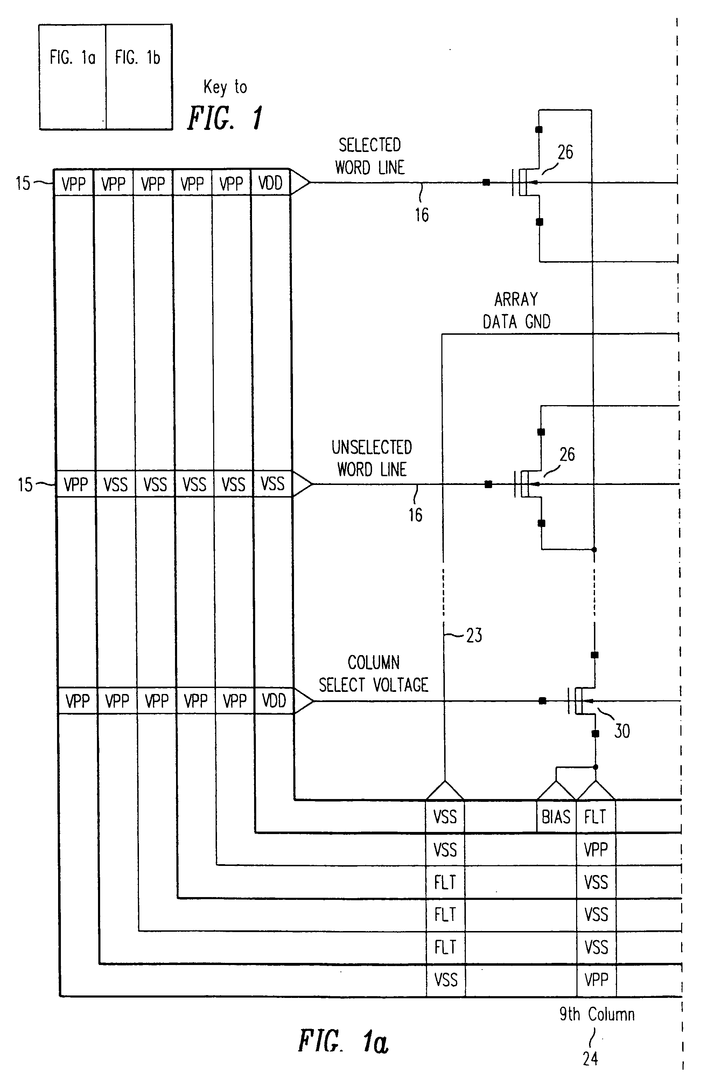

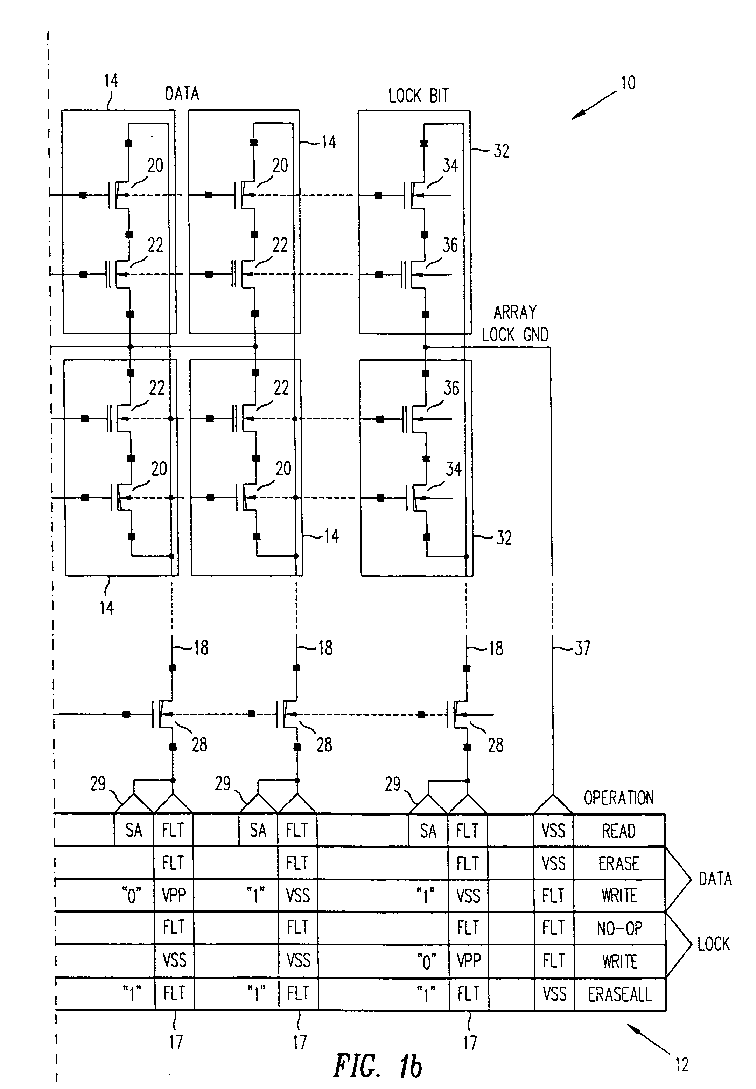

Figure 1 is a schematic diagram of an electrically erasable memory having a lock bit associated with each word (e.g., byte) of data and also a table of exemplary voltages therefor, in accordance with an embodiment of the present invention.

### DETAILED DESCRIPTION OF THE PREFERRED EMBODIMENTS

The preferred embodiments of the present invention and their advantages are best understood by referring to Figure 1 of the drawing. In the drawing, like numerals are used for like and corresponding parts.

### Overall Architecture

Figure 1 is a schematic diagram of an electrically erasable memory 10 having a lock bit associated with each word (e.g., byte) of data and also a table 12 of exemplary voltages therefor, in accordance with an embodiment of the present invention. Memory 10 can be implemented in any suitable EE memory technology.

### Memory Cells

Memory 10 includes a plurality of memory cells 14, each of which is preferably a non-volatile memory cell. Memory cells 14 store or maintain data. In particular, separate bits of data may be written into, stored, and read out of each of memory cells 14.

Memory cells 14 within memory 10 are organized in an array format comprising rows 15 and columns 17. Data stored within memory cells 14 along a row 15 can be grouped in words, such as eight-bit bytes. Although Figure 1 depicts only two bits of one byte for each row 15, it should be understood that, in general, each row 15 may comprise a plurality of bytes. The columns 17 supporting a multi-bit word collectively form a "word column" which, for each eight-bit word, is referred to as a "byte column." Although the remainder of this description primarily discusses bytes and byte columns, it should be understood that the invention is not so limited. A column select voltage selects the active byte column, and thus, the selected byte along a row 15, as further described herein.

Each row 15 of memory cells 14 is accessible by a respective row line or word line 16. Each column 17 of memory cells 14 is accessible by a respective column line or bit line 18. As such, an addressing scheme utilizing (*X,Y*) coordinates can be used to read data from and write data into memory cells 14 based upon their locations at the intersections of particular rows 15 and columns 17. In particular, each word line 16 is selectable with a respective *Y* address, and each group of eight bit lines 18 (constituting a byte column) is selectable with a respective *X* address. Thus, word lines 16 and bit lines 18 constitute select lines for memory 10.

A separate column select transistor 28 is coupled along each bit line 18. Each column select transistor 28 of a selected byte is turned on to select the corresponding group of eight columns 17 of memory cells 14 for reading and writing. Current flows through a column select transistor 28 when a conducting EE memory cell (here, arbitrarily defined as containing a logic value of "0") is being read from any memory cell 14 along the respective bit line 18.

A separate sense amplifier (SA) 29 is coupled to each column select transistor 28 for each of the eight bits of the selected byte column. Sense amplifiers 29 can "read" the logic values stored in memory cells 14 by detecting the presence or absence of current flow through respective column select transistors 28, as described below in more detail. In one embodiment, the operation of column-select transistors 28 routes sense amplifiers 29 to a selected byte column so that these sense amplifiers 29 can be shared among a plurality of byte columns.

As depicted, each memory cell 14 comprises a select transistor 20 coupled to a respective memory transistor 22. Each select transistor 20 is controlled by a respective word line 16. Select transistors 20 are used to pass voltage to the respective memory transistors 22. Each memory transistor 22 functions to hold a "0" or a "1" logic value for a data bit. Each memory transistor 22 can be implemented as a floating gate transistor having two gates--a floating gate and a control gate. The floating gate--which is surrounded by dielectric, and hence, completely isolated--serves to collect and trap charge in order to change the effective threshold of the respective memory transistor 22. The control gate is physically located above the floating gate. Voltage is applied via the control gate to control charging and discharging of the floating gate during programming and to apply suitable bias voltage during reading.

When the floating gate of a memory transistor 22 is charged, that transistor possesses a relatively high threshold voltage (here, considered to be programmed to a logic value "1" state). The effective threshold of the memory transistor 22 is raised, for example, to a value of 5V. Alternatively, when the floating gate of a memory transistor 22 is discharged, that transistor is here considered to be in a logic value "0" state, and the effective threshold of the transistor can be, for example, -1V.

Memory transistors 22 are coupled to a node labeled as "ARRAY DATA GND" in Figure 1. In general, all memory cells 14 in a byte column are connected to ARRAY DATA GND. A separate common line 23 for ARRAY DATA GND is provided for each byte column and runs parallel to the bit lines 18 of the respective columns 17. Common line 23 is controlled at the end of the memory cell array.

### Ninth Column

A ninth column 24 is provided in memory 10 along with the eight columns 17 of memory cells 14 for each byte column. Ninth column 24 comprises a number of transistors 26 (depicted here as depletion transistors), one for each row 15 of memory cells 14. Transistors 26 of ninth column 24 are coupled to the memory cells 14 of the respective rows 15 and can be selected by word lines 16. These transistors 26 route the appropriate control signals to the control gates of memory transistors 22 of the memory cells 14 for either reading data or writing new data. Ninth column transistors 26 can be implemented with depletion-type transistors to convey full control voltages without a transistor-threshold drop. As such, each transistor 26 can pass the required voltage to the control gate of every memory transistor 22 in the associated byte and the respective row 15.

For reading, the magnitude of the voltage passed to selected memory transistors 22 is typically referred to as voltage control gate (VCG) bias. VCG bias is generally set to be an intermediate voltage between the two effective threshold voltages of a memory transistor 22. For example, if the threshold voltage of a memory transistor 22 is 5V for the logic value "1" state and -1V for the logic value "0" state, then VCG bias can have a value of 2.5V.

VCG bias is passed to a memory transistor 22 in order to read from that memory transistor 22. In particular, if the memory transistor 22 stores a logic value "0," the effective threshold voltage is low (e.g., -1V) and the transistor conducts.

Alternatively, if the stored logic value is a "1," the effective threshold voltage is high (e.g., 5V) and the memory transistor 22 does not conduct. If memory transistor 22 conducts, the current is passed through a respective bit line 18 via respective select transistor 20 and column select transistor 28 to a sense amplifier 29 which is operable to detect that current is flowing, thereby differentiating between a logic value "0" and a logic value "1."

### Lock Bit Cells

A separate lock bit cell 32 is coupled to each group of memory cells 14 storing a data byte. Each lock bit cell 32 functions to store a lock bit, which can be set to lock or unlock the bits of data in the respective byte for writing. In one embodiment, for any given row 15, when the associated lock bit has a logic value of "1," the data word is unlocked and the data contained in respective memory cells 14 can be overwritten. Alternatively, when the lock bit has a logic value of "0," the associated data byte is considered locked and, consequently, controlled to inhibit writing.

Lock bit cells 32 can be identical to memory cells 14, thus facilitating the manufacture of the memory array. In particular, each lock bit cell 32 may comprise a select transistor 34 and a memory transistor 36. Each select transistor 34 allows the respective lock bit cell 32 to be selected. Each memory transistor 36 can be implemented with a floating gate transistor having a control gate and a floating gate. Memory transistors 36 maintain the values for the corresponding lock bits. In one embodiment, for any given memory transistor 36, when the floating gate is charged, the lock bit has a logic value "1" which is defined to be unlocked. Alternatively, when the floating gate is not charged, the lock bit has a logic value "0" which is defined to be locked. Memory transistors 36 can have two effective threshold voltages, one of which corresponds to the charged (e.g., unlocked) state and the other of which corresponds to the un-charged (e.g., locked) state.

Each memory transistor 36 is coupled to a node labeled "ARRAY LOCK GND" in Figure 1. In general, all lock bit cells 32 supporting a particular byte column are connected to an associated ARRAY LOCK GND. ARRAY LOCK GND is distinct from ARRAY DATA GND to which memory cells 14 of the byte column are coupled. A separate common line 37 for ARRAY LOCK GND is provided for each byte column and runs parallel to bit lines 18 of the respective word column. Common line 37 is controlled at the end of the memory cell array.

The state or logic value of a lock bit for a selected data byte may be detected by a sense amplifier 29, which can be connected to the respective lock bit cell 32 via a column select transistor 28. Control logic coupled to such sense amplifier 29 determines whether or not the respective data byte can be overwritten based upon the state of the lock bit. In general, every write operation for a selected byte is preceded by a read operation which determines the state of the respective lock bit.

### Operation - In General

The operation of memory 10 is best understood with reference to table 12, which depicts the organization and state of exemplary control signals for two adjacent rows 15 of an address-selected byte column. One of the respective word lines 16 for the two rows 15 is address selected; only two bits of the byte and the associated lock bit are shown.

Table 12 provides voltages for exemplary reading and writing operations of the memory cells 14 contained in the two rows 15. As shown, each of these voltages may have a value of supply voltage (VDD), internally-generated high voltage (VPP), ground (VSS), or floating (FLT).

### Reading Operation

In order to read a given byte of data from a row 15, a respective word line 16 (selected by its Y address) is raised to external supply voltage VDD, thus turning on the select transistors 20 (of memory cells 14) and the ninth column transistor 26 along that row 15. The bit lines 18 in the byte column for the desired byte (selected by respective *X* addresses) are connected to sense amplifiers 29 via column-select transistors 28. The nodes ARRAY DATA GND and ARRAY LOCK GND are connected to VSS or ground, thus completing the electrical paths to the sense amplifiers 29.

Ninth column 24 is raised to a read-bias (BIAS) voltage, which is routed, via a transistor 30 and the respective ninth column transistor 26, to the control gates of the memory transistors 22 and 36 in the memory cells 14 and lock bit cells 32 of the selected row 15. BIAS voltage has the value of voltage control gate (VCG) bias. VCG bias is set to be an intermediate voltage between the two effective threshold voltages of memory transistors 22 and 36 in memory cells 14 and lock bit cell 32. Thus, the BIAS voltage turns on any memory transistor 22 or 36 which stores a logic value "0," but not a memory transistor which stores a logic value "1." When turned on, a memory transistor 22 or 36 conducts current; alternatively, when a memory transistor 22 or 36 is turned off, no current flows. The sense amplifiers 29 detect the absence or presence of current, thus differentiating between the two logic states for each of the memory transistors 22 and 36 in the selected row 15.

### Writing Operation

In order to write a byte of data into the memory cells 14 of a selected row 15, a two step programming sequence is followed. The first step is generally referred to as "erasing" (e.g., to all "ls"), and the second step is generally referred to as "writing" (i.e., a new pattern).

In the first step, the potential at ninth column 24 is raised to high voltage VPP, and the potential at nodes ARRAY DATA GND and ARRAY LOCK GND are brought to VSS. Bit lines 18 float (i.e., are disconnected). VPP is applied, via a respective word line 16, to the control gate of each memory transistor 22 within the memory cells 14 of the selected row 15. This charges the corresponding floating gates, thereby effectively writing a logic value "1" to each of the memory transistors 22 and 36.

Such erasing operation of the first step ensures that all memory transistors 22 and 36 are non-conducting as the second step is initiated, thus eliminating the possibility of sneak current paths. Sneak current paths along the node ARRAY DATA GND can occur if memory transistors 22 programmed with a logic value "0" have previously been driven to depletion, thereby causing them to conduct even with a low voltage (e.g., 0V) on their control gates. Such a sneak current path could drag down the internally generated VPP during the writing operation of the second step. Writing "1" into a lock transistor 36 re-enforces its unlocked state.

In the second step, the potential at ninth column 24 is brought to VSS, and the potential at nodes ARRAY DATA GND and ARRAY LOCK GND float. High voltage VPP is selectively applied, via respective column select transistors 28, to various memory cells 14 in the selected row 15. More specifically, the potential of each bit line 18 is either lowered to VSS so that the logic value "1" is retained in the respective memory transistor 22, or raised to VPP so that the logic value "0" is written in the respective memory transistor 22. The potential of bit line 18 of the lock bit is set to VSS, thus retaining the unlocked "1" state.

### Locking Operation

The writing operation described above--by which a data word is written into the memory cells 14 of a selected row 15--is subject to the state of the lock bit contained in the respective lock bit cell 32. When the lock bit is set as "unlocked," new data can be written into the memory cells 14 of the corresponding row 15. When the lock bit is set as "locked," however, control logic inhibits new data from being be written into the memory cells 14.

In one embodiment, a lock bit is defined to be "unlocked" when the respective lock bit cell 32 contains a logic value "1." This coincides with the state of the lock bit cell 32 after it has been erased. A lock bit cell 32 can be erased--thus generating or reinforcing an unlocked state--by bringing the potential at node ARRAY LOCK GND to VSS when the associated data word is erased. Furthermore, a bit line 18 for lock bit cell 32 must grounded during the second step of a writing operation in order for the respective lock bit to remain in the unlocked (e.g., erased) state.

Continuing with the embodiment described immediately above, a lock bit is defined to be "locked" when the respective lock bit cell 32 contains a logic value "0." A logic value "0" can be written into the lock bit cell 32 by selecting the word line 16 for the corresponding data byte, bringing the voltage potential of ninth column 24 to VSS, and raising the voltage of the bit line 18 for the lock bit cell 32 to VPP. The bit lines 18 for the corresponding memory cells 14 are grounded at this time to prevent alteration of the data byte contained therein.

For writing a logic value "0" into a lock bit cell 32, an initial erase step is not performed because such step could affect the corresponding data word. Accordingly, when it is desired to set the logic value of a lock bit to "0," control logic (not explicitly shown) either eliminates the erase step or, as indicated in table 12, creates "no-op" conditions on the control lines (comprising word lines 16 and bit lines 18).

Prior to the writing of any data byte into the memory cells 14 of a row 15 in memory 10, the contents of the associated lock bit cell 32 must first be read to determine the state of the lock bit. If the lock bit is set to "locked" (e.g., a logic value "0"), control logic inhibits or prevents the writing of that data byte, thus preserving the current contents of the relevant memory cells 14. Because writing of the data byte is thus made impossible, the set condition of the lock bit to "locked" is also preserved.

In one embodiment, provision can be made in the control logic to over-ride the write-inhibit state of the lock bit, for example, for purposes of testing.

As described herein, an embodiment of the present invention provides a separate lock bit for each word (e.g., byte) of data stored in respective memory cells 14 of a memory device 10. After reading a "0" state of the lock bit, control logic prevents alteration of the contents of the respective memory cells 14.

An embodiment of the present invention also provides an architecture for incorporating the lock bit. This architecture includes a simple modification to a well-proven layout and (*X,Y*) addressing structure of an EE memory. In particular, a separate lock bit cell 32 is provided for the lock bit proximate the memory cells 14 which store the associated byte of data. The lock bit cells 32 for the lock bits can be set using at least a portion of the same (*X,Y*) select lines for the associated data bytes. Only one additional bit line 18 per byte column is required. Accordingly, relative to EE memories implemented with previously developed techniques, such architecture of the present invention does not require a significant increase in die size and retains the manufacturability of the well-proven array structure.

While particular embodiments of the present invention have been shown and described, it will be obvious to those skilled in the art that changes and modifications may be made without departing from this invention in its broader aspects and.

## Claims

1. An integrated circuit memory comprising:
a plurality of memory cells operable to store a data word; and
a lock bit cell coupled to the memory cells, the lock bit cell operable to store a lock bit associated with the data word, the lock bit operable to be set to a locked state to prevent overwriting of the data word.

2. The integrated circuit memory of Claim 1 wherein:
the memory cells are selectable with a plurality of select lines; and
the lock bit cell is selectable with a portion of the same plurality of select lines.

3. The integrated circuit memory of Claim 1 wherein:
the memory cells are each coupled to a first array ground node; and
the lock bit cell is coupled to a second array ground node.

4. The integrated circuit memory of Claim 1 further comprising a transistor coupled to the memory cells and the lock bit cell, the transistor operable to pass a high voltage to the memory cells and the lock bit cells.

5. The integrated circuit memory of Claim 4 wherein the transistor comprises a depletion type transistor.

6. An integrated circuit memory comprising:
a plurality of memory cells each selectable with a word line and a respective bit line, the memory cells operable to store a data word; and
a lock bit cell selectable with the same word line as that for selecting the memory cells and a respective bit line, the lock bit cell operable to store a lock bit associated with the data word, the lock bit operable to be set to a locked state to prevent overwriting of the data word.

7. The integrated circuit memory of Claim 6 wherein each memory cell comprises:
a select transistor coupled to the word line; and
a memory transistor coupled to the respective select transistor and to an array data ground node, the memory transistor operable to maintain a logic value for a respective bit of the data word.

8. The integrated circuit memory of Claim 6 wherein the lock bit cell comprises:
a select transistor coupled to the word line; and
a memory transistor coupled to the select transistor and to an array lock ground node, the memory transistor operable to maintain a logic value for the lock bit.

9. The integrated circuit memory of Claim 6 further comprising a transistor coupled to the word line, the transistor operable to pass a high voltage to the memory cells and the lock bit cells.

10. An integrated circuit memory comprising:
a word column having plurality of memory cells organized into groups, each group of memory cells selectable with a respective word line and operable to store a respective data word, each memory cell within a group selectable with a respective bit line; and
a lock bit column having a plurality of lock bit cells, each lock bit cell associated with a respective group of memory cells, each lock bit cell selectable with the same word line as that for selecting the associated group of memory cells and a respective bit line, each lock bit cell operable to store a respective lock bit, each lock bit operable to be set to a locked state to prevent overwriting of the data word stored in the associated group of memory cells.

11. The integrated circuit memory of Claim 10 further comprising a transistor column comprising a plurality of transistors, each transistor associated with a respective group of memory cells, each transistor operable to pass a high voltage to each memory cell in the associated group of memory cells.

12. The integrated circuit memory of Claim 10 wherein:
the memory cells are each coupled to an array data ground node; and
the lock bit cells are each coupled to an array lock ground node.

13. The integrated circuit memory of Claim 1 or 10 wherein each memory cell and each lock bit cell comprises a select transistor coupled to the respective word line.

14. The integrated circuit memory of Claim 1 or 10 wherein:
each memory cell comprises a memory transistor operable to maintain a logic value for a respective bit of the respective data word; and
each lock bit cell comprises a memory transistor operable to maintain a logic value for the respective lock bit.

15. The integrated circuit memory of Claim 17 wherein each memory transistor comprises a floating gate transistor.
